# FASCICULE DE BREVET EUROPEEN

(11) **EP 3 724 762 B1**
(45) Date de publication et mention de la délivrance du brevet: **07.07.2021**
(21) Numéro de dépôt: 18833099.7
(22) Date de dépôt: 13.12.2018
(51) Int. Cl.: G06F 11/07, G01R 29/08, G01R 31/00

(54) **PROCEDE DE TRAITEMENT D'UN SIGNAL COMPRENANT UNE DETECTION DE PERTURBATIONS CAUSEES PAR UN IMPACT DE FOUDRE**
VERFAHREN ZUR VERARBEITUNG EINES SIGNALS MIT DETEKTION VON DURCH BLITZSCHLAG VERURSACHTEN STÖRUNGEN
METHOD FOR PROCESSING A SIGNAL COMPRISING DETECTION OF INTERFERENCE CAUSED BY A LIGHTNING STRIKE

(30) Priorité: 14.12.2017 FR 1762138
(43) Date de publication de la demande: 21.10.2020
(73) Titulaire: SAFRAN ELECTRONICS & DEFENSE, 92100 Boulogne Billancourt (FR)
(72) Inventeur: CONQ, Mathieu, 92100 BOULOGNE-BILLANCOURT (FR); GENESTE, Nicolas, 92100 BOULOGNE-BILLANCOURT (FR); FERNANDES GOMES, Manuel, 92100 BOULOGNE-BILLANCOURT (FR)
(74) Mandataire: Regimbeau
(86) Numéro de dépôt international: PCT/FR2018/053262
(87) Numéro de publication internationale: WO 2019/115953

(56) Documents cités:
- EP-A1- 2 955 488
- WO-A1-2007/000882
- US-A- 5 525 906
- Anonymous: "EUROCAE ED 14 : ENVIRONMENTAL CONDITIONS AND TEST PROCEDURES FOR AIRBORNE EQUIPMENT", , 1 janvier 2015 (2015-01-01), XP055569597, Extrait de l'Internet: URL:https://global.ihs.com/doc_detail.cfm? document_name=EUROCAE%20ED%2014&item_s_key =00156824 [extrait le 2019-03-15]

## Description

### DOMAINE TECHNIQUE GENERAL ET CONTEXTE DE L'INVENTION

La présente invention se rapporte au domaine du traitement d'un signal d'une unité de commande électronique embarquée dans un aéronef, et porte plus précisément sur une détection de perturbations causées par un impact de foudre dans un système de commande électronique embarqué dans un aéronef.

Les aéronefs modernes sont munis de diverses unités de commande électroniques servant à relever les mesures de capteurs et/ou à commander divers dispositifs, tels que moteur ou train d'atterrissage. Un aéronef évoluant en altitude est particulièrement concerné par le risque de foudroiement, par son éloignement de toute autre objet susceptible d'attirer la foudre, mais également en raison de la possible proximité de cumulonimbus. Même si un aéronef peut être partiellement protégé des effets de la foudre par le rôle de cage de faraday joué par sa carlingue, la foudre peut engendrer divers effets électriques dans les constituants électroniques de l'aéronef. Notamment, une unité de commande électronique disposée dans la nacelle d'une turbomachine d'un aéronef est particulièrement exposée.

Un effet de la foudre est la possibilité d'apparition d'erreurs dans des données, en particulier lorsque la foudre impacte l'aéronef au moment où l'ECU acquiert la mesure d'un capteur, ce qu'il fait continuellement. La foudre peut alors avoir pour effet des perturbations électriques dans le capteur et/ou les connexions entre le capteur et l'ECU, qui se traduisent par des erreurs, c'est-à-dire des données erronées non conforme à ce qui aurait dû être acquis par l'ECU en l'absence de foudre.

La présence de telles erreurs peut avoir de grave conséquence. En effet, les données acquises par l'ECU peuvent être utilisées pour commander des organes sensibles de l'aéronef, comme par exemple un moteur. L'utilisation de données invalides pour commander un organe sensible peut engendrer la génération d'une commande non adaptée aux conditions de vol, comme par exemple l'arrêt du moteur.

La demande de brevet EP 2 955 488 décrit une topologie de conditionnement de signal qui est cohérente avec une méthodologie pour convertir différents types d'entrées, incluant des signaux de capteur en courant alternatifs en des unités équivalentes utilisables en ingénierie, et indique que l'utilisation d'un filtrage numérique dans un conditionneur permet de mieux rejeter les bruits à l'extérieur de la bande de fréquence d'intérêt, qui peuvent être présents dans un environnement d'avionique en raison des interférences électriques ou de la foudre. Toutefois, il s'avère que le simple filtrage des bruits à l'extérieur de la bande de fréquence d'intérêt ne permet pas de corriger l'exploitation des données, qui peuvent être altérées dans la bande de fréquence d'intérêt lors d'un impact de foudre. Les documents US 5 525 906 A et WO 2007/000882 A1 décrivent des implémentations permettant de traiter un signal utile affecté par des interférences résultant d'impulsion électromagnétiques sporadiques à l'aide d'un second filtrage passe-bande ayant une seconde bande passante en dehors de celle du signal utile.

### PRESENTATION DE L'INVENTION

L'invention vise à permettre de limiter les effets du foudroiement d'un aéronef, en permettant d'identifier des données susceptibles d'avoir été corrompues par un foudroiement de l'aéronef, d'une façon simple et qui ne nécessite pas de détecter l'impact de foudre en lui-même.

A cet effet, l'invention propose un procédé de traitement d'un signal d'une unité de commande électronique embarquée dans un aéronef, dans lequel ladite unité de commande électronique :
- reçoit un signal d'entrée comprenant des données utiles dans bande utile de fréquences,
- met en œuvre un premier filtrage passe-bande du signal d'entrée avec une première bande passante pour obtenir un signal utile contenant les données utiles, ladite première bande passante comprenant la bande utile,
- exploite lesdites données utiles,
dans lequel l'unité de commande électronique met en outre en œuvre une correction de l'exploitation des données utiles par une détection de perturbations causées par un impact de foudre comprenant les étapes suivantes :
- un second filtrage passe-bande du signal d'entrée pour obtenir un signal de détection, le filtrage passe-bande étant avec une seconde bande passante dans laquelle un signal d'entrée qui a subi des perturbations liées à un impact de foudre est susceptible de présenter des anomalies, la seconde bande passante étant distincte de la première bande passante et étant comprise dans une plage de fréquence 1 kHz - 15 kHz, une réponse en fréquence du premier filtrage passe-bande présentant un lobe principal et des lobes secondaires, une réponse en fréquence du second filtrage passe-bande présentant un lobe principal et des lobes secondaires, le lobe principal du premier filtrage passe-bande et le lobe principal du second filtrage passe-bande ne se chevauchant pas ;
- une comparaison entre au moins une valeur de détection dérivée du signal de détection et un seuil de détection dont le dépassement est indicatif d'un impact de foudre, et
- si la valeur de détection dépasse le seuil de détection, une correction de l'exploitation des données utiles.

Le procédé proposé permet de détecter d'éventuels effets d'un impact de foudre dans un signal utile, en exploitant la présence de perturbations dans le signal d'entrée en dehors de la bande de fréquence utile dans laquelle sont situées les données utiles. La détection se fait en même temps que le traitement du signal utile, et permet donc de corriger l'exploitation des données utiles qui ont pu être affectées par l'impact de foudre.

L'invention est avantageusement complétée par les différentes caractéristiques suivantes :
- le signal d'entrée ne comprend pas de données utiles dans la seconde bande passante ;
- la correction de l'exploitation des données utiles comprend la non prise en compte par l'unité de commande électronique de données utiles synchrones du dépassement du seuil de détection par la valeur de détection dérivée du signal de détection ;
- la correction de l'exploitation des données utiles comprend la détermination d'un biais à partir du signal de détection, et la correction de ce biais dans le signal utile et/ou les données utiles préalablement à l'exploitation des données utiles ;
- la seconde bande passante est supérieure à la première bande passante ;
- la première bande passante est comprise dans une plage de fréquence 1 Hz - 10 kHz ;
- la valeur de détection dérivée du signal de détection est représentative d'une énergie du signal de détection ;
- les lobes secondaires du premier filtrage passe-bande hors du lobe principal du second filtrage passe-bande et les lobes secondaires du second filtrage passe-bande hors du lobe principal du premier filtrage passe-bande présentent des extinctions pour les mêmes fréquences ;
- pour mettre en œuvre le premier filtrage passe-bande du signal d'entrée pour obtenir un signal utile, l'unité de commande électronique applique une démodulation du signal d'entrée au moyen d'un premier signal sinusoïdal de référence à une première fréquence comprise dans la première bande passante pour obtenir le signal utile, et pour mettre en œuvre le second filtrage passe-bande du signal d'entrée pour obtenir un signal de détection, l'unité de commande électronique met en œuvre une démodulation du signal d'entrée au moyen d'un second signal sinusoïdal de référence à seconde fréquence comprise dans la seconde bande passante distincte de la première bande passante pour obtenir le signal de détection ;
- la seconde fréquence est un multiple entier de la première fréquence.

L'invention concerne également un produit programme d'ordinateur comprenant des instructions de code de programme enregistrées sur un support non transitoire utilisable dans un ordinateur pour l'exécution des étapes d'un procédé selon l'invention lorsque ledit programme est exécuté sur un ordinateur utilisant ledit support non transitoire.

L'invention concerne également une unité de commande électronique embarquée dans un aéronef, ladite unité de commande électronique étant configurée pour mettre en œuvre un procédé selon l'invention.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 montre schématiquement un diagramme de principe d'étapes mises en œuvre dans un mode de réalisation possible de l'invention ;
- la figure 2 illustre de façon schématique un exemple de démodulation numérique pouvant être mis en œuvre dans un mode de réalisation possible de l'invention réaliser un filtrage passe-bande d'un signal ;
- la figure 3 montre des exemples de réponse en fréquence d'un premier filtrage passe-bande et d'un second filtrage passe-bande réalisés au moyen de démodulations numériques ;
- la figure 4 montre un exemple de profil spectral du résultat d'une transformation de Fourier rapide appliquée à un signal modélisant une perturbation générée par un impact de foudre.

### DESCRIPTION DETAILLEE

Le procédé est mis en œuvre par une unité de commande électronique embarquée dans un aéronef. L'aéronef peut être tout engin évoluant dans les airs, tels qu'un avion, un hélicoptère, ou un drone par exemple. Une unité de commande électronique, généralement désignée par les initiales ECU, de l'anglais "Electronic Control Unit", désigne un calculateur embarqué ou système embarqué qui reçoit des signaux de mesures de capteurs ou des signaux en provenance d'autres calculateurs, et commande des dispositifs physique ou fournit des signaux à d'autres calculateurs. Un exemple d'unité de commande électronique auquel s'applique l'invention est la commande électronique numérique principale généralement désignée par les initiales FADEC, de l'anglais *"Full Authority Digital Engine Control".* Il s'agit d'un système de commande numérique qui s'interface entre le cockpit et un moteur d'un aéronef pour la commande de celui-ci. Plus précisément, le FADEC contrôle tous les circuits d'un moteur en réponse aux commandes données de l'avion, communiquant aussi des informations à l'aéronef pour fournir les indications au poste de pilotage, pour la surveillance du comportement en service du moteur, pour le rapport de maintenance et les recherches de pannes. Un autre exemple d'unité de commande électronique est une unité servant à relever des mesures capteurs pour les traiter et les transmettre au FADEC, et qui est donc à l'origine de données traitées par le FADEC. Dans la mesure où le foudroiement d'un aéronef peut entraîner des anomalies dans la plupart des systèmes électroniques embarqués, la détection de perturbations causées par un impact de foudre peut être mise en œuvre dans toute unité de commande électronique mettant en œuvre un procédé de traitement d'un signal comprenant des données utiles dans une bande de fréquences déterminée.

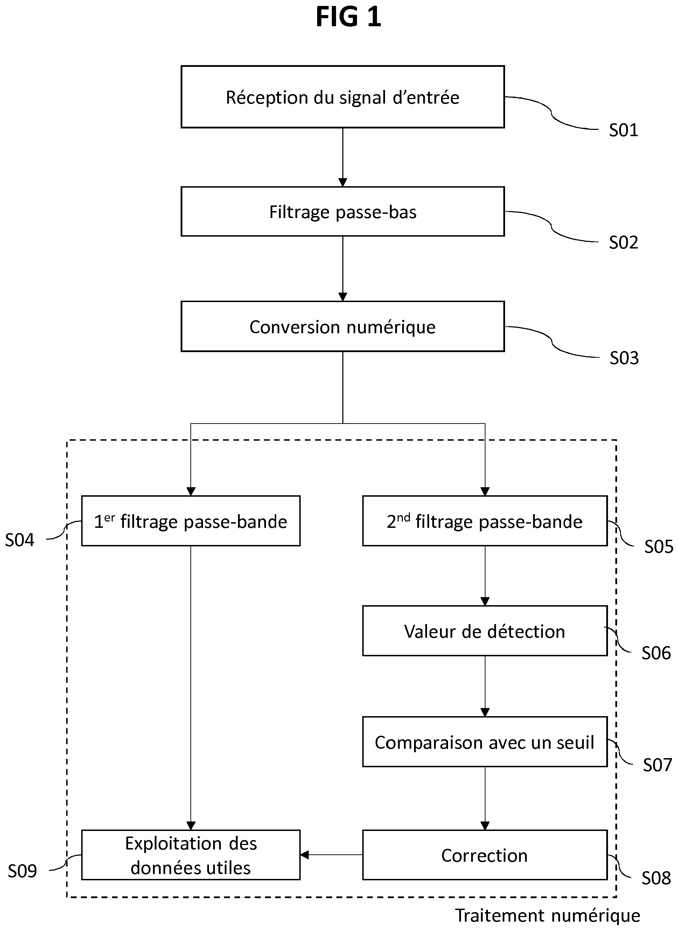

En référence à la figure 1, le procédé de traitement d'un signal comprend une première étape S01 de réception du signal d'entrée. Ce signal d'entrée comprend des données utiles dans une bande de fréquences, dite bande utile. Par exemple, le signal d'entrée peut comprendre des données codées en amplitude modulées par un signal sinusoïdal. De préférence, la bande utile est comprise dans une plage de fréquence 1 Hz - 10 kHz. La bande utile peut être réduite à une seule fréquence.

A titre d'exemple non limitatif utilisé à fin d'illustration, un transformateur différentiel à variation linéaire (ou LVDT pour l'anglais "linear variable-differential transformer") est utilisé pour mesurer les déplacements d'une vanne moteur. Un tel transformateur génère un signal constitué par une sinusoïde à une fréquence de 3 kHz dont l'amplitude est proportionnelle au déplacement de la vanne moteur. Les données utiles sont ici constituées par les amplitudes du signal, tandis que la bande utile est centrée autour de la fréquence 3 kHz, et peut par exemple être considérée comme étant comprise entre 2 kHz et 4 kHz par exemple. Bien entendu, l'invention peut s'appliquer à des signaux en provenance d'autres composants, comme par exemple un résolveur déterminant l'angle d'une manette de commande.

De manière préférentielle, le traitement subséquent du signal est un traitement numérique. A cet effet, une étape de filtrage passe-bas S02 peut être prévue, afin d'éviter des problèmes de repliement du spectre, en choisissant la fréquence de coupure en fonction de la fréquence d'échantillonnage de la conversion numérique à venir. Bien entendu, cette fréquence de coupure du filtrage passe-bas doit être supérieure aux bandes de fréquence utilisées par la suite. Un convertisseur analogique numérique met ensuite en œuvre une conversion numérique S03 pour transformer le signal d'entrée analogique en signal d'entrée numérique.

L'unité de commande électronique met ensuite en œuvre un premier filtrage passe-bande (étape S04) du signal d'entrée, avec une première bande passante pour obtenir un signal utile contenant les données utiles. Bien entendu, la première bande passante recouvre la bande utile. On entend par bande passante la bande de fréquences dans toute laquelle l'affaiblissement reste inférieur à une valeur spécifiée, correspondant conventionnellement à une énergie réduite de moitié (-3 dB), c'est-à-dire à une amplitude réduite de 70%, par rapport au maximum. De préférence, la première bande passante est centrée sur la bande utile. Il existe plusieurs manières de faire ce premier filtrage passe-bande. Une solution est de convertir le signal d'entrée dans le domaine fréquentiel et de sélectionner la plage de fréquence adéquate, en l'occurrence correspondant à la première bande passante. On peut pour cela utiliser par exemple une transformation de Fourier rapide.

Toutefois, dans le cadre de l'exemple de cette description où le signal d'entrée est basé sur un signal sinusoïdal, il est préférable que l'unité de commande électronique applique une démodulation du signal d'entrée au moyen d'un premier signal sinusoïdal de référence à une première fréquence comprise dans la bande utile pour obtenir le signal utile. En effet, une telle démodulation est simple à mettre en œuvre et demande moins de ressource que le recours à une transformation de Fourier rapide.

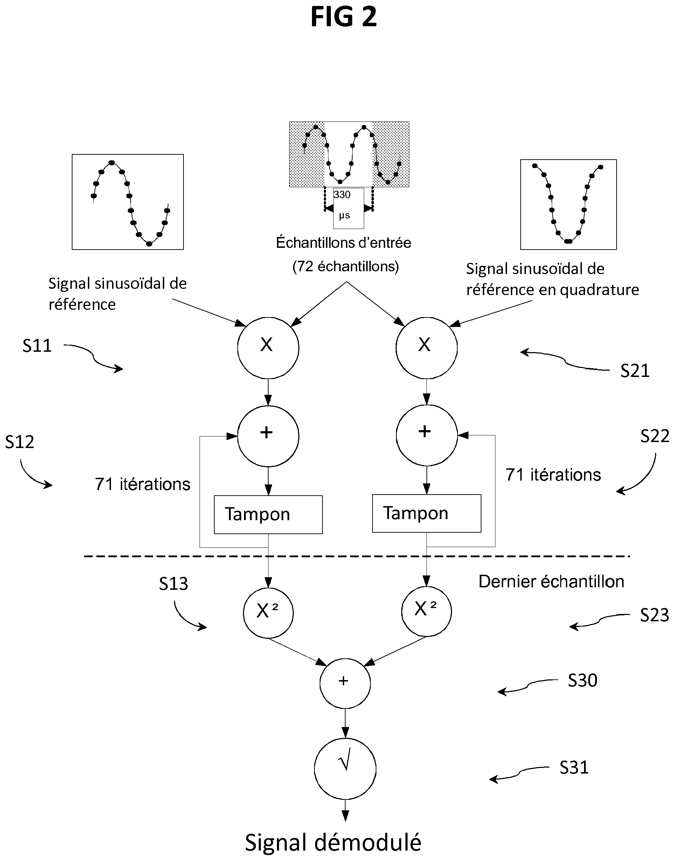

La figure 2 montre un exemple de mise en œuvre d'une telle démodulation numérique. Cette modulation s'effectue sur des fenêtres temporelles successives. Dans l'exemple illustré, une fenêtre temporelle s'étend sur 330 µs, correspondant à 72 échantillons pour une fréquence d'échantillonnage d'environ 220 kHz. Les opérations décrites sont donc effectuées sur ces 72 échantillons d'entrée. Le premier signal sinusoïdal de référence présente une même fréquence d'échantillonnage et le même nombre d'échantillons. Dans l'exemple illustratif, le premier signal sinusoïdal de référence est une sinusoïde à une fréquence 3 kHz, comme la fréquence du signal émis par le transformateur différentiel à variation linéaire.

Le traitement se scinde en deux branches. Dans une première branche, les échantillons d'entrée sont multipliés (étape S11) par les échantillons du premier signal sinusoïdal de référence avant d'être sommés (étape S12) au cours de 71 itérations au cours desquels les résultats intermédiaires sont stockés dans une mémoire tampon. A la suite du traitement du dernier des 72 échantillons, la somme résultante est élevée au carré (étape S13).

Dans la seconde branche, les échantillons d'entrée sont multipliés (étape S21) par les échantillons du premier signal sinusoïdal de référence en quadrature, c'est-à-dire décalés d'un quart de période. Ainsi, si le premier signal sinusoïdal de référence est un sinus, le premier signal sinusoïdal de référence en quadrature est un cosinus de même amplitude et même période. Ensuite, les échantillons résultants sont sommés (étape S22) au cours de 71 itérations au cours desquels les résultats intermédiaires sont stockés dans une mémoire tampon. A la suite du traitement du dernier des 72 échantillons, la somme résultante est élevée au carré (étape S23).

Les résultats des deux branches sont ensuite sommés (étape S30), puis la racine carrée de la somme résultante est calculée (étape S31). Il en résulte le signal démodulé. Dans le cas du premier filtrage passe-bande, on obtient ainsi le signal utile.

Dans le même temps, l'unité de commande électronique met en œuvre un second filtrage passe-bande (étape S05) du signal d'entrée, avec une seconde bande passante pour obtenir un signal de détection. La seconde bande passante est distincte de la première bande passante et est comprise dans une plage de fréquence 1 kHz - 15 kHz. De préférence, la seconde bande passante est supérieure à la première bande passante. De préférence, la première bande passante et la seconde bande passante sont séparées par au moins 0,5 kHz. Dans l'exemple illustratif, la seconde bande passante est centrée sur 9 kHz. De fait, la seconde bande passante est de préférence centrée sur une fréquence qui est un multiple entier de la fréquence sur laquelle est centrée la première bande passante.

Le second filtrage passe-bande peut obéir aux mêmes modalités que celles du premier filtrage passe-bande décrites plus haut. En particulier, on peut mettre en œuvre une transformation de Fourier rapide. Toutefois, comme pour le premier filtrage passe-bande, pour mettre en œuvre le second filtrage passe-bande du signal d'entrée pour obtenir un signal de détection, l'unité de commande électronique met de préférence en œuvre une démodulation du signal d'entrée au moyen d'un second signal sinusoïdal de référence à une seconde fréquence comprise dans la seconde bande passante distincte de la première bande passante pour obtenir le signal de détection. Dans l'exemple illustratif, le second signal sinusoïdal de référence est une sinusoïde à une fréquence de 9 kHz. La démodulation numérique pour obtenir le signal de détection peut se faire selon les modalités décrites en référence à la figure 2.

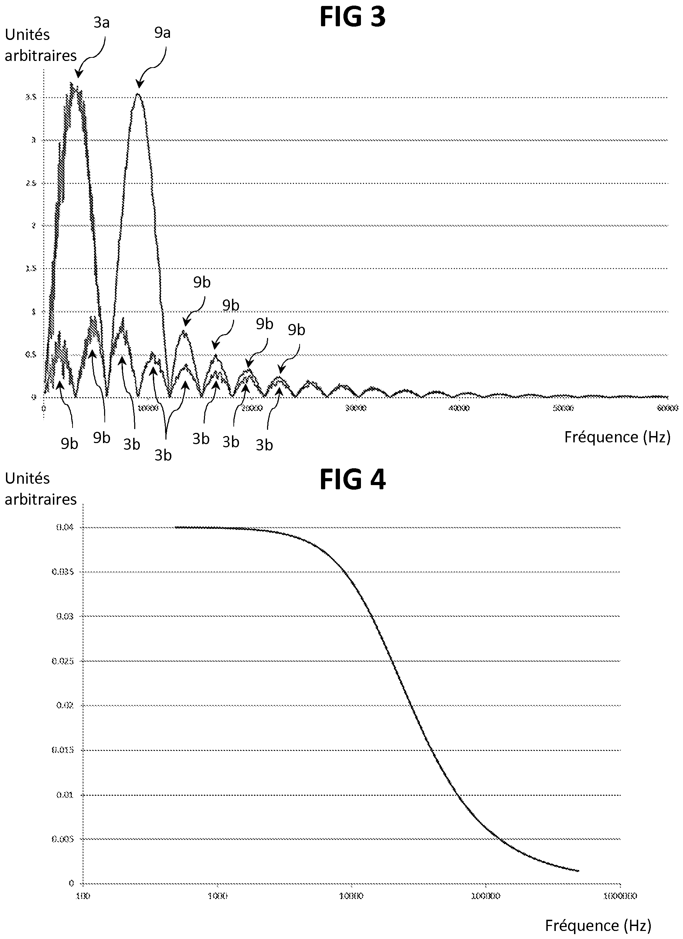

La figure 3 montre des exemples de réponse en fréquence d'un premier filtrage passe-bande et d'un second filtrage passe-bande réalisés au moyen des démodulations numériques précédemment décrites, dans le cadre de l'exemple illustratif. On y retrouve, en unités arbitraires et en fonction de la fréquence en Hertz :
- la réponse du premier filtrage passe-bande, avec un lobe principal 3a centré sur la première fréquence à 3 kHz et des lobes secondaires 3b d'amplitudes moindres ; et
- la réponse du second filtrage passe-bande, avec un lobe principal 9a centré sur la seconde fréquence à 9 kHz, et des lobes secondaires 9b d'amplitudes moindres.

On constate que le lobe principal 3a du premier filtrage passe-bande et le lobe principal 9a du second filtrage passe-bande ne se chevauchent pas. Par ailleurs, on peut voir que les bandes passantes du premier filtrage passe-bande et du second filtrage passe-bande, correspondant conventionnellement à une énergie réduite de moitié (-3 dB), c'est-à-dire à une amplitude réduite de 70%, par rapport au maximum, sont clairement distinctes, et séparées d'au moins 0,5 kHz. Ces caractéristiques sont particulièrement avantageuses et sont de préférence recherchées pour le premier filtrage passe-bande et le second filtrage passe-bande.

L'unité de commande électronique détermine ensuite une valeur de détection dérivée du signal de détection (étape S06). Cette valeur de détection est représentative de l'énergie du signal de détection. En l'absence d'impact de foudre, l'énergie du signal de détection est proche de zéro, puisque le signal d'entrée ne comprend pas de données utiles dans la seconde bande passante. Il reste donc essentiellement du bruit dans le signal de détection. La valeur de détection est par exemple une amplitude moyenne, une énergie du signal, une densité spectrale de puissance, etc... Bien entendu, plusieurs valeurs de détection peuvent être utilisées pour une même portion du signal.

L'unité de commande électronique compare ensuite (étape S07) cette valeur de détection à un seuil de détection. Le seuil de détection dépend bien entendu du choix qui a été fait pour la nature de la valeur de détection, mais également de la sensibilité recherchée. Typiquement, le seuil de détection doit être plus élevé que les valeurs de détection qu'est susceptible de générer le bruit, afin de limiter les fausses détections. Lorsque la valeur de détection dépasse le seuil de détection, c'est-à-dire est plus éloigné du zéro que ne l'est le seuil de détection, cela signifie que des anomalies sont présentes dans le signal d'entrée dans la seconde bande passante, alors même qu'il n'y a pas de données utiles dans cette seconde bande passante. Ces anomalies ne sont pas dues au bruit, puisque la comparaison au seuil de détection à éliminer cette possibilité. Ces anomalies sont donc vraisemblablement causées par un impact de foudre.

En effet, un impact de foudre induit typiquement des signaux électriques parasites sur les câblages connectant des composants électroniques de l'aéronef, voire sur dans les composants électroniques eux-mêmes (notamment dans les capteurs). Par exemple, la figure 4 montre un exemple de profil spectral du résultat d'une transformation de Fourier rapide appliquée à un signal modélisant une perturbation générée par un impact de foudre avec une abscisse logarithmique. Plus précisément, il s'agit du spectre de la forme d'onde WF6 telle que définie dans le document RTCA DO-160G "Environmental Conditions and test Procédures for Airborne Equipment", également référencé sous la dénomination EUROCAE ED-14G.

On constate que cette forme d'onde présente un haut niveau dans la bande de fréquence [100 Hz ; 15 kHz]. Ainsi, un signal d'entrée qui a subi des perturbations liées à un impact de foudre est susceptible de présenter des anomalies dans cette même bande de fréquence. En recherchant la présence de ces anomalies dans une bande de fréquence distincte de la bande utile où se trouvent les données utiles, on peut détecter qu'un impact de foudre a eu lieu. Or, les perturbations ont pu corrompre les données utiles.

Comme cette détection a lieu en même temps que le traitement des données utiles du signal d'entrée, il est possible de mettre en œuvre une correction (étape S08) de l'exploitation des données utiles présentent dans le signal utile (étape S09). Cette correction peut être mise en œuvre préalablement au traitement des données utiles ou simultanément. Cette correction peut comprendre une action sur le signal utile ou sur les données utiles, ou simplement une modification dans l'exploitation de ces données utiles. En particulier, la correction de l'exploitation des données utiles peut comprendre la non prise en compte par l'unité de commande électronique de données utiles synchrones du dépassement du seuil de détection par la valeur de détection dérivée du signal de détection. En effet, puisque le dépassement du seuil de détection est indicatif d'un impact de foudre, les données utiles peuvent être altérées ; mieux vaut ne pas les prendre en compte. Dans l'exemple illustratif, l'amplitude du signal utile ne sera donc pas utilisée pour déterminer le déplacement d'une vanne moteur, à titre temporaire.

Toutefois, plutôt que de perdre les données utiles en ne les traitant pas, il peut être avantageux d'utiliser le signal de détection pour corriger le signal utile et/ou les données utiles. En effet, ainsi que visible sur la figure 4, le profil spectral d'une perturbation générée par un impact de foudre présente une densité relativement constante dans la plage 1 kHz - 10 kHz. Par conséquent, il est probable que les conséquences de l'impact de foudre dans le signal de détection soient les mêmes que dans le signal utile.

De préférence, la correction de l'exploitation des données utiles comprend ainsi la détermination d'un biais à partir du signal de détection, et la correction de ce biais dans le signal utile et/ou les données utiles préalablement à l'exploitation des données utiles. Dans l'exemple illustratif, si le signal de détection présente une amplitude de 50 mV, alors on peut soustraire 50 mV de l'amplitude du signal utile, celui-présentant normalement des valeurs comprises entre 5 et 6 V. De fait, il est préférable de ne procéder à la correction de biais que s'il représente en valeur moins de 20 % de la valeur des données utiles.

Toutefois, afin de corriger correctement un tel biais, il est préférable que la réponse en fréquence du premier filtrage passe-bande et la réponse en fréquence du second filtrage passe-bande présentent certaines similarités au niveau de leurs lobes secondaires 3b, 9b. De préférence, les lobes secondaires 3b du premier filtrage passe-bande hors du lobe principal 9a du second filtrage passe-bande et les lobes secondaires 9b du second filtrage passe-bande hors du lobe principal 3a du premier filtrage passe-bande présentent des extinctions pour les mêmes fréquences. Les lobes secondaires 3b, 9b, en dehors des zones de chevauchement avec les lobes principaux 3a, 3b, se chevauchent alors. Pour ce faire, la seconde fréquence est de préférence un multiple entier de la première fréquence utilisée pour la démodulation lors du premier filtrage passe-bande. Ainsi, dans l'exemple illustratif, la première fréquence est de 3 kHz tandis que la deuxième fréquence est de 9 kHz, soit une multiplication par un facteur 3.

L'invention n'est pas limitée au mode de réalisation décrit et représenté aux figures annexées. Des modifications restent possibles, sans sortir pour autant du domaine de protection défini par les revendications.

## Revendications

1. Procédé de traitement d'un signal d'une unité de commande électronique embarquée dans un aéronef, dans lequel ladite unité de commande électronique :
- reçoit (S01) un signal d'entrée comprenant des données utiles dans une bande utile de fréquences,
- met en œuvre un premier filtrage passe-bande (S04) du signal d'entrée avec une première bande passante pour obtenir un signal utile contenant les données utiles, ladite première bande passante comprenant la bande utile,
- exploite lesdites données utiles (S09), l'unité de commande électronique mettant en outre en œuvre une correction de l'exploitation des données utiles par une détection de perturbations causées par un impact de foudre comprenant les étapes suivantes :
- un second filtrage passe-bande (S05) du signal d'entrée pour obtenir un signal de détection, le filtrage passe-bande étant avec une seconde bande passante dans laquelle un signal d'entrée qui a subi des perturbations liées à un impact de foudre est susceptible de présenter des anomalies, la seconde bande passante étant distincte de la première bande passante et étant comprise dans une plage de fréquence 1 kHz - 15 kHz, une réponse en fréquence du premier filtrage passe-bande présentant un lobe principal et des lobes secondaires, une réponse en fréquence du second filtrage passe-bande présentant un lobe principal et des lobes secondaires, le lobe principal du premier filtrage passe-bande et le lobe principal du second filtrage passe-bande ne se chevauchant pas,
- une comparaison (S07) entre au moins une valeur de détection dérivée du signal de détection et un seuil de détection dont le dépassement est indicatif d'un impact de foudre, et
- si la valeur de détection dépasse le seuil de détection, une correction de l'exploitation des données utiles (S08).

2. Procédé selon la revendication 1, dans lequel le signal d'entrée ne comprend pas de données utiles dans la seconde bande passante.

3. Procédé selon l'une des revendications 1 à 2, dans lequel la correction de l'exploitation des données utiles comprend la non prise en compte par l'unité de commande électronique de données utiles synchrones du dépassement du seuil de détection par la valeur de détection dérivée du signal de détection.

4. Procédé selon l'une des revendications 1 à 3, dans lequel la correction de l'exploitation des données utiles comprend la détermination d'un biais à partir du signal de détection, et la correction de ce biais dans le signal utile et/ou les données utiles préalablement à l'exploitation des données utiles.

5. Procédé selon l'une des revendications 1 à 4, dans lequel la seconde bande passante est supérieure à la première bande passante.

6. Procédé selon l'une des revendications 1 à 5, dans lequel la première bande passante est comprise dans une plage de fréquence 1 Hz - 10 kHz

7. Procédé selon l'une des revendications 1 à 6, dans lequel la valeur de détection dérivée du signal de détection est représentative d'une énergie du signal de détection.

8. Procédé selon l'une des revendications précédentes, dans lequel les lobes secondaires du premier filtrage passe-bande hors du lobe principal du second filtrage passe-bande et les lobes secondaires du second filtrage passe-bande hors du lobe principal du premier filtrage passe-bande présentent des extinctions pour les mêmes fréquences.

9. Procédé selon l'une des revendications 1 à 8, dans lequel pour mettre en œuvre le premier filtrage passe-bande du signal d'entrée pour obtenir un signal utile, l'unité de commande électronique applique une démodulation du signal d'entrée au moyen d'un premier signal sinusoïdal de référence à une première fréquence comprise dans la première bande passante pour obtenir le signal utile, et pour mettre en œuvre le second filtrage passe-bande du signal d'entrée pour obtenir un signal de détection, l'unité de commande électronique met en œuvre une démodulation du signal d'entrée au moyen d'un second signal sinusoïdal de référence à une seconde fréquence comprise dans la seconde bande passante distincte de la première bande passante pour obtenir le signal de détection.

10. Procédé selon la revendication 9, dans lequel la seconde fréquence est un multiple entier de la première fréquence.

11. Produit programme d'ordinateur comprenant des instructions de code de programme enregistrées sur un support non transitoire utilisable dans un ordinateur pour l'exécution des étapes d'un procédé selon l'une des revendications 1 à 10 lorsque ledit programme est exécuté sur un ordinateur utilisant ledit support non transitoire.

12. Unité de commande électronique embarquée dans un aéronef, ladite unité de commande électronique étant configurée pour mettre en œuvre un procédé selon l'une des revendications 1 à 10.

## Patentansprüche

1. Verfahren zur Verarbeitung eines Signals einer in ein Luftfahrzeug eingebauten elektronischen Steuerungseinheit, wobei die elektronische Steuerungseinheit:
- ein Eingangssignal empfängt (S01), das nutzbare Daten in einem nutzbaren Frequenzband umfasst,
- eine erste Passbandfilterung (S04) des Eingangssignals mit einer ersten Bandbreite durchführt, um ein nutzbares Signal zu erhalten, das die nutzbaren Daten enthält, wobei die erste Bandbreite das nutzbare Band umfasst,
- die nutzbaren Daten (S09) verwertet,
wobei die elektronische Steuerungseinheit weiter eine Korrektur der Verwertung der nutzbaren Daten durch eine Detektion von Störungen ausführt, die durch Blitzschlag verursacht werden, die folgenden Schritte umfassend:
- eine zweite Passbandfilterung (S05) des Eingangssignals, um ein Detektionssignal zu erhalten, wobei die Passbandfilterung mit einer zweiten Bandbreite erfolgt, bei der ein Eingangssignal, welches Störungen erfahren hat, die mit Blitzschlag zu tun haben, Anomalien aufweisen könnte, wobei sich die zweite Bandbreite von der ersten Bandbreite unterscheidet, und in einem Frequenzbereich von 1 kHz - 15 kHz enthalten ist, wobei eine Frequenzantwort der ersten Passbandfilterung eine Hauptkeule und Nebenkeulen aufweist, eine Frequenzantwort der zweiten Passbandfilterung eine Hauptkeule und Nebenkeulen aufweist, wobei sich die Hauptkeule der ersten Passbandfilterung und die Hauptkeule der zweiten Passbandfilterung nicht überschneiden,
- einen Vergleich (S07) zwischen mindestens einem Detektionswert, der von dem Detektionssignal und einem Detektionsschwellenwert abgeleitet wird, dessen Überschreitung auf Blitzschlag hinweist, und
- wenn der Detektionswert den Detektionsschwellenwert überschreitet, eine Korrektur der Verwertung der nutzbaren Daten (S08).

2. Verfahren nach Anspruch 1, wobei das Eingangssignal keine nutzbaren Daten in der zweiten Bandbreite umfasst.

3. Verfahren nach einem der Ansprüche 1 bis 2, wobei die Korrektur der Verwertung der nutzbaren Daten die Nicht-Berücksichtigung, durch die elektronische Steuerungseinheit, von nutzbaren Daten umfasst, die synchron mit der Überschreitung des Detektionsschwellenwerts durch den Detektionswert sind, der von dem Detektionssignal abgeleitet ist.

4. Verfahren nach einem der Ansprüche 1 bis 3, wobei die Korrektur der Verwertung der nutzbaren Daten die Bestimmung einer Verzerrung ausgehend vom Detektionssignal, und die Korrektur dieser Verzerrung in dem nutzbaren Signal und/oder den nutzbaren Daten vor der Verwertung der nutzbaren Daten umfasst.

5. Verfahren nach einem der Ansprüche 1 bis 4, wobei die zweite Bandbreite größer als die erste Bandbreite ist.

6. Verfahren nach einem der Ansprüche 1 bis 5, wobei die erste Bandbreite in einem Frequenzbereich von 1 Hz - 10 kHz enthalten ist.

7. Verfahren nach einem der Ansprüche 1 bis 6, wobei der von dem Detektionssignal abgeleitete Detektionswert repräsentativ für eine Energie des Detektionssignals ist.

8. Verfahren nach einem der vorstehenden Ansprüche, wobei die Nebenkeulen der ersten Passbandfilterung außerhalb der Hauptkeule der zweiten Passbandfilterung und die Nebenkeulen der zweiten Passbandfilterung außerhalb der Hauptkeule der ersten Passbandfilterung Auslöschungen für dieselben Frequenzen aufweisen.

9. Verfahren nach einem der Ansprüche 1 bis 8, wobei die elektronische Steuerungseinheit zum Ausführen der ersten Passbandfilterung des Eingangssignals zum Erhalt eines nutzbaren Signals eine Demodulation des Eingangssignals anhand eines ersten Referenz-Sinussignals auf eine erste Frequenz anwendet, die in der ersten Bandbreite enthalten ist, um das nutzbare Signal zu erhalten, und die elektronische Steuerungseinheit zum Ausführen der zweiten Passbandfilterung des Eingangssignals zum Erhalt eines Detektionssignals, eine Demodulation des Eingangssignals anhand eines zweiten Referenz-Sinussignals auf eine zweite Frequenz anwendet, die in der zweiten Bandbreite enthalten ist, die sich von der ersten Bandbreite unterscheidet, um das Detektionssignal zu erhalten.

10. Verfahren nach Anspruch 9, wobei die zweite Frequenz ein ganzes Vielfaches der ersten Frequenz ist.

11. Computerprogrammprodukt, welches Programmcodeanweisungen umfasst, die in einem nichtflüchtigen Speicher abgelegt sind, der in einem Computer zur Ausführung der Schritte eines Verfahrens nach einem der Ansprüche 1 bis 10 nutzbar ist, wenn das Programm auf einem Computer ausgeführt wird, der den nichtflüchtigen Speicher nutzt.

12. Elektronische Steuerungseinheit, die in einem Luftfahrzeug eingebaut ist, wobei die elektronische Steuerungseinheit konfiguriert ist, um ein Verfahren nach einem der Ansprüche 1 bis 10 auszuführen.

## Claims

1. Method for processing a signal of an electronic control unit on board an aircraft, wherein said electronic control unit:
- receives (S01) an input signal comprising useful data in a useful frequency band,
- implements a first band-pass filtering (S04) of the input signal with a first bandwidth to obtain a useful signal containing the useful data, said first bandwidth comprising the useful band,
- uses said useful data (S09),
the electronic control unit also implementing a correction of the use of the useful data by a detection of disturbances caused by a lightning strike comprising the following steps:
- a second band-pass filtering (S05) of the input signal to obtain a detection signal, the band-pass filtering being with a second bandwidth in which an input signal which has undergone disturbances linked to a lightning strike is likely to present anomalies, the second bandwidth being distinct from the first bandwidth and being comprised in a 1 kHz - 15 kHz frequency range, a frequency response of the first band-pass filtering having a main lobe and secondary lobes, a frequency response of the second band-pass filtering having a main lobe and secondary lobes, the main lobe of the first band-pass filtering and the main lobe of the second band-pass filtering not overlapping.
- a comparison (S07) between at least one detection value derived from the detection signal and a detection threshold, whose exceeding is indicative of a lightning strike, and
- if the detection value exceeds the detection threshold, a correction of the use of the useful data (S08).

2. Method according to claim 1, wherein the input signal does not comprise useful data in the second bandwidth.

3. Method according to either of claims 1 to 2, wherein the correction of the use of the useful data comprises not taking into account, by the electronic control unit, useful data simultaneous with the exceeding of the detection threshold by the detection value derived from the detection signal.

4. Method according to one of claims 1 to 3, wherein the correction of the use of the useful data comprises determining a bias from the detection signal, and correcting this bias in the useful signal and/or the useful data prior to the use of the useful data.

5. Method according to one of claims 1 to 4, wherein the second bandwidth is greater than the first bandwidth.

6. Method according to one of claims 1 to 5, wherein the first bandwidth is comprised in a 1 Hz - 10 kHz frequency range.

7. Method according to one of claims 1 to 6, wherein the detection value derived from the detection signal is representative of an energy of the detection signal.

8. Method according to one of the preceding claims, wherein the secondary lobes of the first band-pass filtering outside the main lobe of the second band-pass filtering and the secondary lobes of the second band-pass filtering outside the main lobe of the first band-pass filtering have zeros for the same frequencies.

9. Method according to one of claims 1 to 8, wherein to implement the first band-pass filtering of the input signal to obtain a useful signal, the electronic control unit applies a demodulation of the input signal by means of a first sinusoidal reference signal at a first frequency comprised in the first bandwidth to obtain the useful signal, and to implement the second band-pass filtering of the input signal to obtain a detection signal, the electronic control unit implements a demodulation of the input signal by means of a second sinusoidal reference signal at a second frequency comprised in the second bandwidth distinct from the first bandwidth to obtain the detection signal.

10. Method according to claim 9, wherein the second frequency is an integer multiple of the first frequency.

11. Computer program product comprising program code instructions recorded on a non-transitory medium usable in a computer for the execution of the steps of a method according to any of claims 1 to 10 when said program is executed on a computer using said non-transitory medium.

12. Electronic control unit on board an aircraft, said electronic control unit being configured to implement a method according to one of claims 1 to 10.
